# DEMANDE DE BREVET EUROPEEN

(11) **EP 4 742 295 A1**
(43) Date de publication de la demande: **13.05.2026**
(21) Numéro de dépôt: 25214315.1
(22) Date de dépôt: 07.11.2025
(51) Int. Cl.: H01H 71/12, G01R 1/04, G01R 31/327, H01H 50/04

(54) **DISPOSITIF DE MESURE D'AU MOINS UNE GRANDEUR ÉLECTRIQUE ET SYSTÈME DE DIAGNOSTIC DE FONCTIONNEMENT ASSOCIÉ**

(30) Priorité: 08.11.2024 FR 2412239
(71) Demandeur: SCHNEIDER ELECTRIC INDUSTRIES SAS, 92500 Rueil-Malmaison (FR)
(72) Inventeur: SEDITA, Thibault, 38420 LE VERSOUD (FR); GEFFROY, Vincent, 38000 GRENOBLE (FR); GARCIA, José, 21410 AGEY (FR); MAQUIN, Clément, 38410 SAINT MARTIN D'URIAGE (FR)
(74) Mandataire: Lavoix

(57) **Abrégé**

L'invention concerne un dispositif de mesure (4) d'au moins une grandeur électrique d'un signal électrique circulant dans un dispositif contacteur (2), le dispositif contacteur (2) comportant, pour chaque phase parmi N phases, un élément de contact (18) connecté à un conducteur électrique de phase (15), l'au moins une grandeur électrique comprenant une tension, le dispositif de mesure (4) étant configuré pour être installé en façade dudit dispositif contacteur (2), et comprenant une unité de contrôle électronique (24) comportant N nappes flexibles (26), et pour chaque phase :
-un ensemble de connexion (20) connecté à une desdites nappes flexibles (26),
-une pièce d'actionnement (22) de l'ensemble de connexion (20), configurée pour être déplacée d'une position libre dans laquelle l'ensemble de connexion (20) est isolé électriquement du dispositif contacteur à une position bloquée dans laquelle l'ensemble de connexion (20) est en appui sur un desdits éléments de contact (18) du dispositif contacteur.

## Description

La présente invention concerne un dispositif de mesure d'au moins une grandeur électrique d'un signal électrique circulant dans un dispositif contacteur d'au moins un conducteur électrique dans une installation électrique.

L'invention concerne également un système de diagnostic de fonctionnement d'une installation électrique comportant un tel dispositif de mesure.

L'invention se situe dans le domaine du contrôle de fonctionnement d'installations électriques, et plus particulièrement du diagnostic de fonctionnement d'installations électriques, notamment pour des installations électriques dans des domaines industriels nécessitant le pilotage de moteurs.

De telles installations électriques comprennent des équipements électriques tels des moteurs électriques, résistances de chauffage ou circuits de puissance en général.

On connaît des dispositifs contacteurs configurés pour autoriser ou bloquer une circulation d'un signal électrique à N phases dans l'équipement électrique, N étant un entier supérieur ou égal à 1. Par exemple N=3 dans le cas d'une installation électrique alimentée par un réseau de distribution triphasé.

Un dispositif contacteur comporte un boîtier et des bornes de contact de raccordement (ou bornes de contacts de puissance et bornes de contacts auxiliaires), les diverses bornes étant généralement accessibles en façade du boîtier.

Pour des installations électriques, en général, plusieurs dispositifs contacteurs sont agencés dans une armoire électrique de dimensionnement choisi.

Pour effectuer un diagnostic de fonctionnement d'une installation électrique, par exemple en vue d'effectuer de la maintenance prédictive des équipements électriques connectés, tels des moteurs électriques, il est nécessaire de recueillir des mesures de grandeurs électriques, en particulier des mesures de courant consommé par les charges et de tension entre conducteurs électriques sur des durées de fonctionnement.

Il est préférable d'effectuer des mesures de grandeurs électriques de manière non-invasive, c'est-à-dire sans avoir à effectuer des modifications des câblages dans une installation électrique existante.

De plus, le diagnostic de fonctionnement nécessitant des calculs complexes, il est en général nécessaire de transmettre les mesures de courant et de tension recueillies, par une liaison de communication, à un dispositif de calcul distant doté d'une puissance de calcul suffisante. Pour cela, pour des installations électriques complexes, il est nécessaire d'utiliser une liaison de communication de débit suffisant.

A cet effet, l'invention a pour objet un dispositif de mesure d'au moins une grandeur électrique d'un signal électrique circulant dans un dispositif contacteur d'au moins un conducteur électrique dans une installation électrique, le dispositif contacteur étant configuré pour autoriser ou bloquer une circulation d'un courant électrique à N phases dans au moins un équipement électrique, N étant un entier supérieur ou égal à 1, connecté via ledit au moins un conducteur électrique, le dispositif de mesure comportant un boîtier configuré pour être installé en façade dudit dispositif contacteur, le dispositif contacteur comportant, pour chaque phase, un élément de contact connecté au conducteur électrique de ladite phase et accessible via la façade du dispositif contacteur, l'au moins une grandeur électrique comprenant une tension.

Ce dispositif de mesure comprend une unité de contrôle électronique comportant N nappes flexibles, et pour chaque phase :
- un ensemble de connexion connecté à une desdites nappes flexibles,
- une pièce d'actionnement de l'ensemble de connexion, l'ensemble de connexion étant partiellement inséré dans la pièce d'actionnement, la pièce d'actionnement étant configurée pour être déplacée pour passer, lorsque le dispositif de mesure est installé sur le dispositif contacteur, d'une position libre dans laquelle l'ensemble de connexion est isolé électriquement du dispositif contacteur à une position bloquée dans laquelle l'ensemble de connexion est en appui sur un desdits éléments de contact du dispositif contacteur.

Avantageusement, l'installation du dispositif de mesure proposé ne nécessite pas de câblage électrique, et donc pas de modification dans une installation électrique existante, la tension étant mesurée à partir du signal électrique capté via l'ensemble de connexion et la nappe flexible associée lorsque la pièce d'actionnement est en position bloquée.

Suivant d'autres aspects avantageux de l'invention, le dispositif de mesure comprend une ou plusieurs des caractéristiques suivantes, prises isolément ou suivant toutes les combinaisons techniquement possibles.

La pièce d'actionnement est configurée pour être translatée selon un axe donné et tournée d'un quart de tour autour dudit axe pour passer respectivement de la position libre à la position bloqué et vice-versa.

Le boîtier comporte un capot, le capot comportant N réceptacles de guidage, la pièce d'actionnement étant insérée dans un desdits réceptacles de guidage et étant configurée pour être guidée en translation dans ledit réceptacle de guidage, et dans lequel la pièce d'actionnement comporte au moins un ergot de maintien, ledit ergot de maintien étant configuré pour s'insérer, après translation et rotation autour dudit axe, dans un logement de maintien correspondant formé dans le capot.

L'ensemble de connexion comporte un élément conducteur et un fourreau isolant, le fourreau isolant entourant en partie l'élément conducteur, l'élément conducteur comportant en outre une pointe de touche configurée pour venir en appui sur l'élément de contact en position bloquée.

Chaque nappe flexible comporte un œillet d'extrémité en matériau conducteur, agencé autour de l'ensemble de connexion associé, de sorte à conduire un signal électrique entre ledit ensemble de connexion et l'unité de contrôle électronique lorsque la pièce d'actionnement est en position bloquée.

L'élément conducteur comporte un épaulement, le fourreau isolant étant positionné en appui sur ledit épaulement.

Il comporte en outre un premier ressort et un deuxième ressort, lesdits premier ressort et deuxième ressort entourant l'ensemble de connexion et étant disposés de part et d'autre dudit épaulement, le premier ressort étant disposé entre la pièce d'actionnement et ledit épaulement de l'élément conducteur.

Le deuxième ressort est en matériau conducteur, le deuxième ressort étant configuré pour être en contact avec la nappe flexible en position bloquée, le deuxième ressort réalisant une connexion électrique entre l'élément conducteur) de l'ensemble de connexion et ladite nappe flexible.

Le dispositif de mesure configuré en outre pour effectuer des mesures de courant pour chaque conducteur électrique.

Le dispositif de mesure comporte en outre une interface de communication pour permettre une connexion à un réseau de communication, l'interface de communication étant configurée pour transmettre des messages comportant lesdites mesures d'au moins une grandeur électrique à un dispositif de supervision connecté audit réseau de communication.

L'invention concerne également un système de diagnostic de fonctionnement d'une installation électrique, comportant un dispositif de mesure tel que brièvement décrit ci-dessus, le dispositif de mesure étant installé sur un dispositif de contact de ladite installation électrique, le système de diagnostic comprenant également un dispositif de supervision, le dispositif de mesure étant configuré pour transmettre des mesures d'au moins une grandeur électrique audit dispositif de supervision via un réseau de communication, le dispositif de supervision comportant un contrôleur configuré pour effectuer des calculs de diagnostic de fonctionnement en fonction de l'au moins une mesure de grandeur électrique reçue.

L'invention apparaîtra plus clairement à la lecture de la description qui va suivre, donnée uniquement à titre d'exemple non limitatif, et faite en référence aux dessins dans lesquels :
la figure 1 est une vue en perspective d'un dispositif contacteur et d'un dispositif de mesure installé en façade du dispositif contacteur ;
la figure 2 est une vue en coupe d'un dispositif de mesure et d'un dispositif contacteur selon deux positions distinctes d'un ensemble de connexion du dispositif de mesure ;
la figure 3 représente un ensemble de connexion et une pièce d'actionnement selon un mode de réalisation ;
la figure 4 représente un premier capot d'un dispositif de mesure et un détail d'une pièce d'actionnement ;
la figure 5 représente un détail de la figure 2 en position bloquée ;
la figure 6 représente un deuxième capot d'un dispositif de mesure ;
la figure 7 est un synoptique des principaux blocs fonctionnels d'un système de diagnostic comportant un dispositif de mesure.

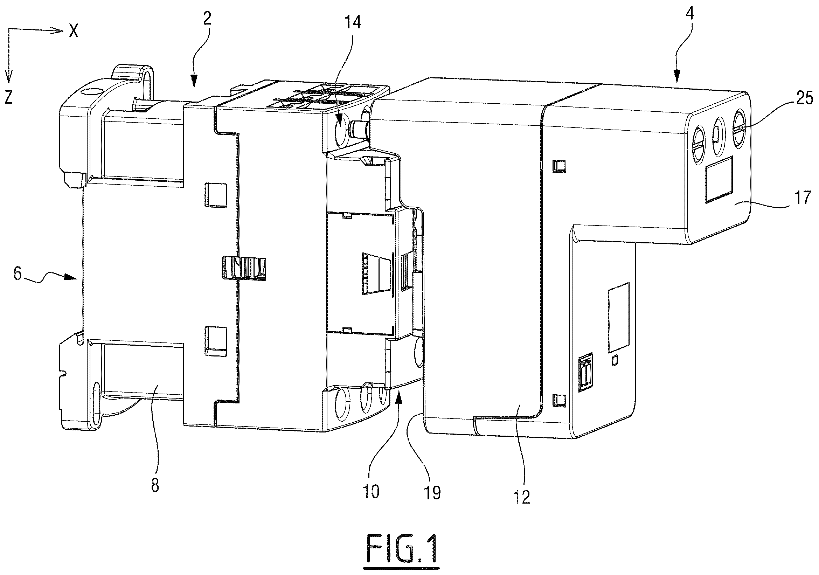

La figure 1 illustre un dispositif contacteur 2 et un dispositif de mesure 4 installé en façade du dispositif contacteur.

Le dispositif contacteur 2 est destiné à être installé dans une installation électrique non représentée.

Dans diverses applications, le dispositif contacteur 2 est installé dans un tableau électrique ou dans une armoire électrique par des pièces de fixation de la partie arrière 6 de son boîtier 8. La face avant du boîtier 8, également appelée façade 10 du dispositif contacteur 2 est accessible pour un opérateur.

Dans la description qui suit, le terme connecté se réfère à une connexion électrique, et le terme conducteur s'entend comme conducteur électrique.

Le dispositif de mesure 4 comporte un boîtier 12, le boîtier 12 du dispositif de mesure étant configuré pour être fixé mécaniquement, par exemple par enclipsage, sur le dispositif contacteur 2, et plus particulièrement sur la face avant 10 du boîtier 8 du dispositif contacteur 2.

Le boîtier 12 comporte un premier capot 17, ou capot avant, et un deuxième capot 19, ou capot arrière, le capot arrière étant au moins partiellement en contact avec la face avant 10 du boîtier 8 lorsque le dispositif de mesure 4 est installé sur le dispositif contacteur 2.

Le dispositif contacteur 2 comporte des bornes de raccordement 14 pour conducteurs électriques (non représentés sur la figure 1).

Dans l'exemple illustré, le dispositif contacteur 2 comporte trois bornes de raccordement 14 correspondant respectivement à une installation électrique à courant triphasé, chaque borne de raccordement étant associée à un conducteur électrique de phase.

Plus généralement, le dispositif contacteur 2 est configuré pour autoriser ou bloquer une circulation de courant électrique à N phases, et comporte un nombre N de bornes de raccordement, N étant un entier supérieur ou égal à 1, de préférence supérieur ou égal à 2.

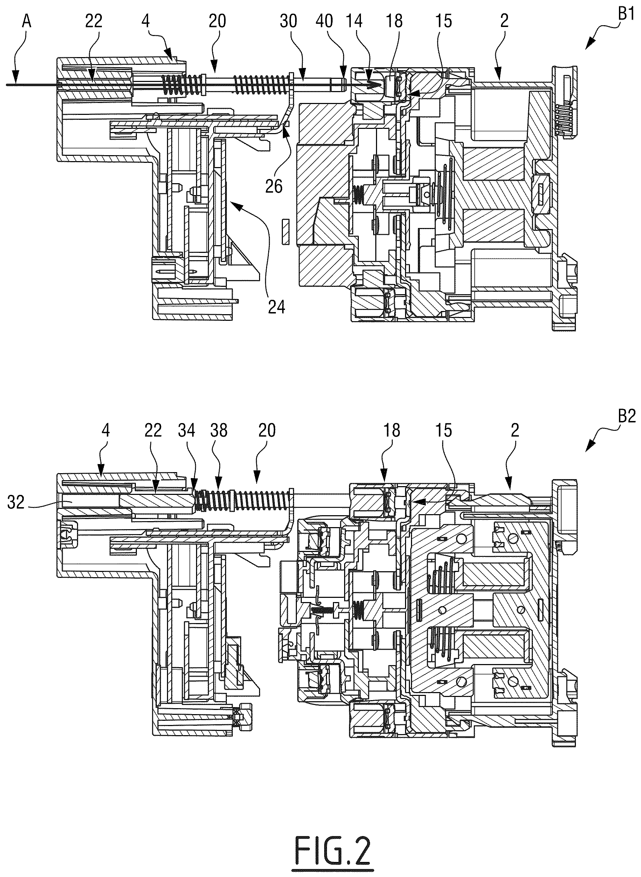

Chaque borne de raccordement 14 respective comprend un élément de contact électrique 18 (également appelé élément de contact 18) avec le conducteur électrique 15, comme illustré dans la figure 2.

Par exemple l'élément de contact électrique 18 est une tête de vis conductrice d'un ensemble de raccordement vis-écrou. Lorsqu'un conducteur électrique 15 est raccordé via une borne de raccordement 14, l'élément de contact électrique 18 est électriquement connecté au conducteur électrique 15.

Le dispositif de mesure 4 est configuré pour mesurer des grandeurs électriques du signal électrique circulant dans le conducteur électrique 15, via un mécanisme de connexion électrique en façade 35 à l'élément de contact électrique 18 de la borne de raccordement 14 correspondante.

Dans la suite de la description, en référence aux figures 2 à 6, sont décrits les éléments contribuant à réaliser ce mécanisme de connexion électrique en façade 35 pour un conducteur électrique de phase 15, étant entendu que le dispositif de mesure 4 comporte autant de mécanismes de connexion électrique en façade que de bornes 14.

La figure 2 représente sur deux inserts référencés B1 et B2 des vues de coupe du dispositif de mesure 4 selon deux positions, respectivement une position dite libre (insert B1) et une position dite bloquée (insert B2), décrites en détail ci-après.

Il est à noter que le dispositif contacteur 2 et le dispositif de mesure 4 sont représentés dans une vue en coupe éclatée dans la figure 2 pour faciliter la compréhension des divers éléments.

Le dispositif de mesure 4 comporte, pour chaque phase, un ensemble de connexion 20 agencé dans une pièce d'actionnement 22. L'ensemble de connexion 20 et la pièce d'actionnement 22 coopèrent pour réaliser le mécanisme de connexion électrique en façade 35.

Le dispositif de mesure 4 comporte également une unité de contrôle électronique 24, comportant N nappes flexibles 26 s'étendant à l'extérieur de l'unité électronique de contrôle, chaque nappe flexible 26 comportant une plage conductrice.

L'ensemble de connexion 20 est inséré partiellement dans la pièce d'actionnement 22, de sorte que le déplacement de la pièce d'actionnement 22 entraîne le déplacement de l'ensemble de connexion 20.

La pièce d'actionnement 22 est insérée dans un réceptacle de guidage 32 du boîtier 12 du dispositif de mesure, en pratique le réceptacle de guidage 32 (ou logement de guidage) étant formé dans le premier capot 17 du boîtier 12 du dispositif de mesure.

La pièce d'actionnement 22 est configurée pour être translatée selon un axe A et tournée d'un quart de tour autour dudit axe.

Dans un mode de réalisation, la pièce d'actionnement 22 est de forme sensiblement cylindrique, et le réceptacle de guidage 32 a une forme analogue, de diamètre adapté par rapport au diamètre de la pièce d'actionnement 22.

L'axe A est défini par rapport au réceptacle 32, par exemple le réceptacle 32 est sensiblement cylindrique et l'axe A est l'axe central du cylindre formant le réceptacle 32.

La pièce d'actionnement 22 comporte un embout 25 doté d'une entaille, accessible en façade du boîtier 12 du dispositif de mesure, adapté pour être poussé et tourné au moyen d'un organe externe, par exemple au moyen d'un tournevis (non représenté sur les figures).

L'agencement du réceptacle 32 et de la pièce d'actionnement 22 dans ce réceptacle est tel que lorsque le dispositif de mesure 4 est installé en façade du dispositif contacteur 2, le logement 32 est aligné avec la borne de raccordement 14, comme montré dans la figure 2.

La pièce d'actionnement 22 est configurée pour être déplacée de la position libre (insert B1) à la position bloquée (insert B2) et vice-versa. En position libre, il n'y a pas de contact avec l'élément de contact 18.

Partant de la position libre (insert B1 de la figure 2), lorsque la pièce d'actionnement 22 est translatée en direction du dispositif contacteur 2 (sens indiqué par la flèche sur l'axe A), l'ensemble de connexion 20 arrive en appui sur l'élément de contact électrique 18 de la borne de raccordement 14 en position bloquée, comme montré dans l'insert B2. Ainsi, en position bloquée, l'ensemble de connexion 20 est en contact physique et en connexion électrique avec l'élément de contact électrique 18 de la borne de raccordement 14.

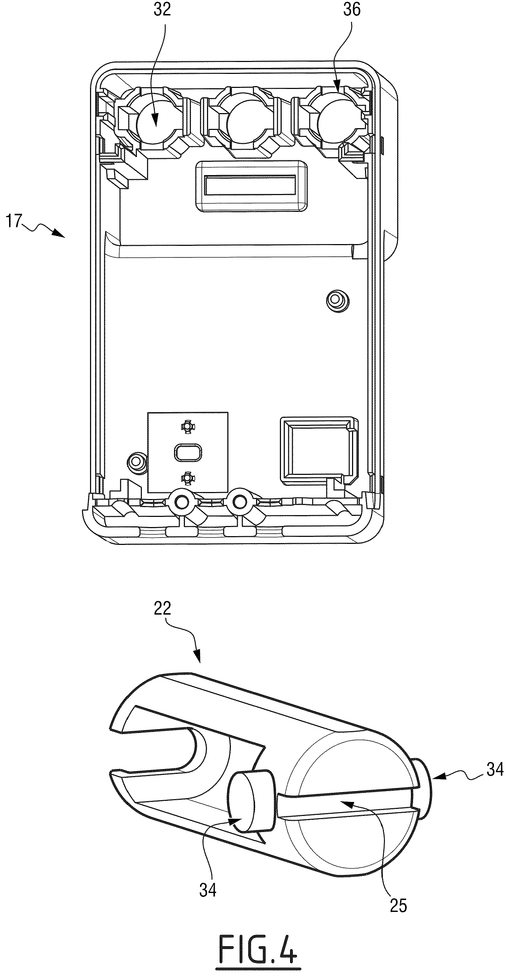

Dans un mode de réalisation, et comme illustré plus en détail dans la figure 4, afin de maintenir l'ensemble de connexion 20 en appui sur l'élément de contact électrique 18, en position bloquée, la pièce d'actionnement 22 comprend des ergots de maintien 34, par exemple deux ergots de maintien diamétralement opposés, configurés pour s'insérer dans des logements de maintien 36 du premier capot 17 du boîtier 12 du dispositif de mesure 4, après translation dans le réceptacle de guidage 32, en direction du dispositif contacteur 2, et rotation d'un quart de tour de la pièce d'actionnement 22 autour de l'axe A.

De plus l'ensemble de connexion 20 est guidé vers la borne de raccordement 14 au travers de logements arrière 31 qui sont formés dans le deuxième capot (ou capot arrière) 19. Le logement arrière 31 est configuré pour être aligné avec la bornes de raccordement 14 lorsque le dispositif de mesure 4 est installé sur le dispositif contacteur 2.

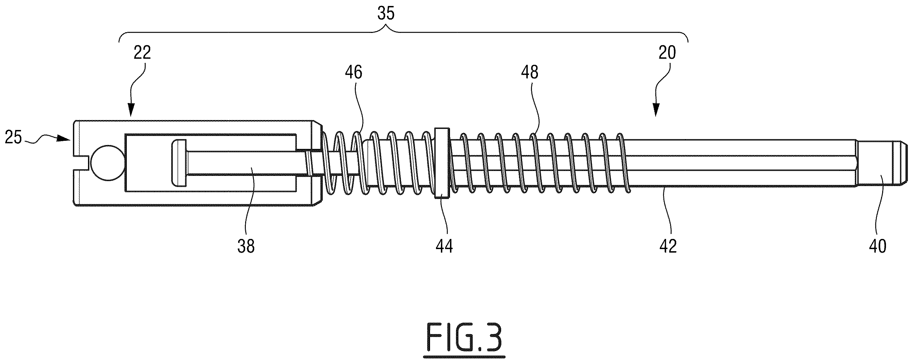

Comme illustré plus en détail dans la figure 3, l'ensemble de connexion 20 comporte un élément conducteur 38, e. g. un élément métallique, comportant une pointe de touche 40, et un fourreau 42 en matériau isolant, par exemple en plastique.

L'élément conducteur 38 forme une âme métallique de l'ensemble de connexion 20 et s'étend sur la totalité de l'ensemble de connexion 20. La pointe de touche 40 est l'extrémité de l'ensemble de connexion 20, située à l'opposé de la pièce d'actionnement 22. La pointe de touche 40 est la partie de l'ensemble de connexion 20 qui vient en appui sur l'élément de contact 18 en position bloquée, et exerce une force de pression sur l'élément de contact 18 dans cette position bloquée.

La pointe de touche 40 a de préférence une forme de disque, de diamètre proche du diamètre de la tête de vis formant l'élément de contact 18.

Comme illustré dans la figure 3, dans un mode de réalisation, le fourreau 42 recouvre en partie l'élément conducteur 38.

De plus, l'élément conducteur 38 comporte un épaulement 44, comme visible plus particulièrement dans la figure 3.

Le fourreau 42 est, dans le mode de réalisation de la figure 3, en appui sur l'épaulement 44.

Le mécanisme de connexion en façade comporte en outre deux ressorts, respectivement un premier ressort 46 et un deuxième ressort 48, qui sont disposés de part et d'autre de l'épaulement 44 de l'élément conducteur 38.

Le premier ressort 46, également appelé ressort de maintien, est disposé entre la pièce d'actionnement 22 et l'épaulement 44 de l'élément conducteur 38 de l'ensemble de connexion. Ce premier ressort 46 a pour fonction le maintien d'une force de contact par appui de la pointe de touche 40 en position bloquée.

De préférence, le premier ressort 46 est choisi de sorte que la force de pression de contact exercée par l'ensemble de connexion 20 sur l'élément de contact 18 soit au moins égale à 1Newton.

Le deuxième ressort 48 a une fonction de ressort de rappel de l'ensemble de connexion lors du démontage du dispositif de mesure 4.

De plus, le deuxième ressort 48 est en matériau conducteur (ressort métallique) et a également une fonction de contact électrique, permettant la circulation d'un signal électrique entre l'élément de contact 18 et l'unité de contrôlé électronique 24, via la nappe flexible 26 qui est connectée électriquement à une extrémité du ressort 48 en position bloquée.

De préférence, l'effort du premier ressort 46, en position bloquée, est supérieur d'au moins 1 Newton à l'effort du deuxième ressort 48.

De préférence le premier ressort 46 et le deuxième ressort 48 sont traités de manière à être conducteurs en surface, par exemple par étamage ou par nickelage.

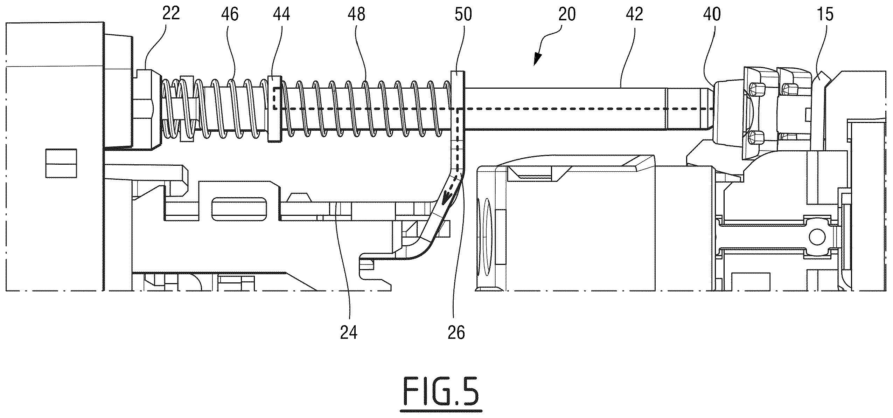

Dans un mode de réalisation la nappe flexible 26 comporte un œillet d'extrémité 50 en matériau conducteur, et l'ensemble de connexion 20 traverse l'œillet d'extrémité 50, comme illustré notamment dans la figure 5.

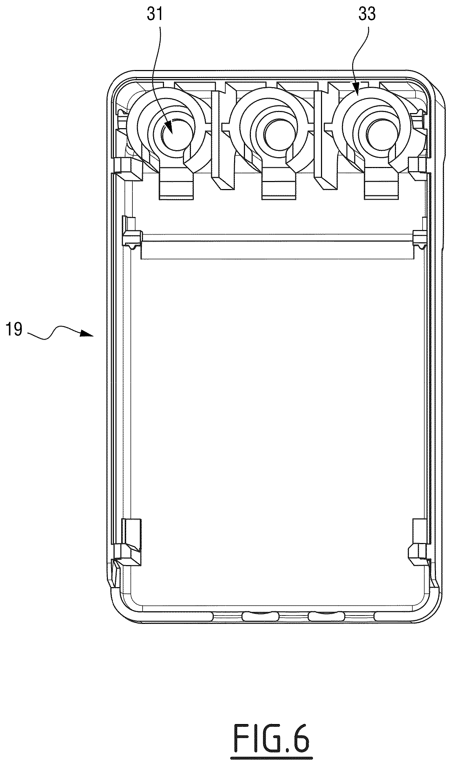

Le deuxième ressort 48 est disposé entre l'épaulement 44 et l'œillet d'extrémité 50. En position bloquée, l'œillet d'extrémité 50 arrivé en butée contre un élément de butée 33, qui appartient au deuxième capot 19 dans un mode de réalisation, illustré dans la figure 6. Dans la position bloquée, une première extrémité du deuxième ressort 48 est en appui sur l'épaulement 44 et une deuxième extrémité du deuxième ressort 48 est en appui sur l'œillet d'extrémité 50, qui est en butée sur l'élément de butée 33. Avantageusement, l'élément de butée 33 permet d'assurer le contact mécanique et la connexion électrique entre l'œillet d'extrémité 50 et le deuxième ressort 48.

Le deuxième ressort 48 conduit un signal électrique entre l'épaulement 44 et l'œillet d'extrémité 50, ce qui permet d'acheminer le signal électrique via la nappe flexible 26 à l'unité de contrôle électronique 24.

Ainsi, la pièce d'actionnement 22, l'ensemble de connexion 20, la nappe flexible 26 et l'unité de contrôle électronique 24, dans l'agencement décrit ci-dessus, coopèrent pour réaliser une mesure de tension au niveau de l'élément de contact électrique 18 du dispositif contacteur 2.

En outre, dans un mode de réalisation, l'unité de contrôle électronique 24 est également configurée pour réaliser des mesures de courant électrique consommé par un une charge (e.g. un équipement électrique) connectée en aval du contacteur 2.

Dans un mode de réalisation, les mesures de courant électrique consommé par la charge (non représentée) sont réalisées par des capteurs de courant disposés sur des câbles de phase raccordés aux bornes aval du contacteur 2. Chaque capteur de courant respectif est relié par un fil conducteur à l'unité de contrôle électronique 4.

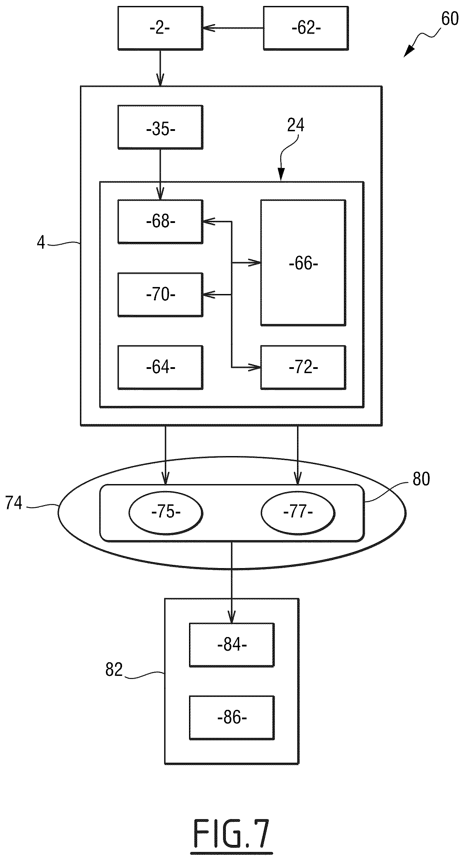

La figure 7 est un synoptique des principaux blocs fonctionnels d'un système 60 de diagnostic de fonctionnement d'une installation électrique comportant au moins un équipement électrique 62 connecté via un dispositif contacteur 2 à une source d'électricité non représentée.

Le système de diagnostic 60 comporte un dispositif de mesure 4 tel que décrit ci-dessus, comportant un mécanisme de connexion en façade 35 tel que décrit, et une unité de contrôle électronique 24, le mécanisme de connexion 35 permettant d'acheminer le signal électrique du dispositif contacteur 2 vers l'unité de contrôle électronique 24, pour chaque conducteur de phase, comme décrit ci-dessus.

L'unité de contrôle électronique 24 est alimentée par une unité d'alimentation 64 et comporte un processeur ou microcontrôleur 66, réalisé par exemple sous forme de circuit électronique conçu pour manipuler et/ou transformer des données représentées par des quantités électroniques ou physiques dans des registres de l'unité de contrôle et/ou des mémoires en d'autres données similaires correspondant à des données physiques dans les mémoires de registres ou d'autres types de dispositifs d'affichage, de dispositifs de transmission ou de dispositifs de mémorisation.

L'unité de contrôle électronique 24 comporte en en outre un module 68 de division et mise en forme de signaux de tension, un module 70 d'acquisition de signaux de courant et de tension et de mise en forme de signaux de courant issus des capteurs de courant respectifs.

Dans des modes de réalisation, le module 66 est réalisé sous forme d'un composant logique programmable, tel qu'un FPGA (de l'anglais *Field Programmable Gate Array*), ou encore d'un circuit intégré, tel qu'un ASIC (de l'anglais *Application Specific Integrated Circuit*). Le module 68 est par exemple réalisé par un pont de résistances. Le module 70 est par exemple un convertisseur analogique numérique (CAN).

L'unité de contrôle électronique 24 comporte en outre une interface de communication 72, configurée pour permettre une connexion à un réseau de communication 74, par exemple un réseau filaire Ethernet 10BASE-T1S.

L'unité de contrôle électronique 24 est ainsi configurée pour fournir des mesures de courant 75 et des mesures de tension 77, qui sont formatées dans des messages de communication 80 et transmises, via le réseau de communication 74, à un dispositif de supervision 82.

Le dispositif de supervision 82 est également muni d'une interface de communication 84, adaptée pour communiquer avec l'interface de communication 72 du dispositif de mesure.

Le dispositif de supervision 82 comporte en outre un contrôleur 86 configuré pour effectuer des calculs de diagnostic de fonctionnement en fonction des mesures de grandeurs électriques mesurées reçues, i.e. des mesures de tension et des mesures de courant reçues, selon des procédés de diagnostic de fonctionnement connus.

Selon des variantes, le dispositif de mesure est configuré pour fournir des mesures de tension 77 seulement, et le dispositif de supervision 82 est configuré pour effectuer des calculs de diagnostic de fonctionnement à partir des mesures de tension reçues.

Ainsi, il est possible à partir d'un tel diagnostic de fonctionnement de mettre en exergue des situations qui dévient d'un fonctionnement nominal, et de prévoir par la suite des mesures de maintenance prédictive afin d'éviter la survenue d'une défaillance de l'équipement électrique 62.

Avantageusement, le dispositif de mesure 4 est muni d'une interface de communication permettant d'effectuer des communications à débit suffisant pour transmettre des mesures de tension, et optionnellement des mesures de courant, permettant de réaliser des calculs de diagnostic de fonctionnement.

Avantageusement, le dispositif de mesure 4 peut être installé en façade d'un dispositif contacteur 2 sans avoir à effectuer une quelconque modification des câblages électriques. Ainsi, l'installation d'un tel dispositif est aisée et non-invasive, elle est compatible avec la prise de mesure sur des installations électriques existantes.

## Revendications

1. Dispositif de mesure (4) d'au moins une grandeur électrique d'un signal électrique circulant dans un dispositif contacteur (2) d'au moins un conducteur électrique (15) dans une installation électrique, le dispositif contacteur (2) étant configuré pour autoriser ou bloquer une circulation d'un courant électrique à N phases dans au moins un équipement électrique, N étant un entier supérieur ou égal à 1, connecté via ledit au moins un conducteur électrique (15), le dispositif de mesure (4) comportant un boîtier (12) configuré pour être installé en façade (10) dudit dispositif contacteur (2), le dispositif contacteur (2) comportant, pour chaque phase, un élément de contact (18) connecté au conducteur électrique (15) de ladite phase et accessible via la façade (10) du dispositif contacteur (2), l'au moins une grandeur électrique comprenant une tension,
le dispositif de mesure (4) étant **caractérisé en ce qu'**il comprend une unité de contrôle électronique (24) comportant N nappes flexibles (26),
et pour chaque phase :
- un ensemble de connexion (20) connecté à une desdites nappes flexibles (26),
- une pièce d'actionnement (22) de l'ensemble de connexion (20), l'ensemble de connexion (20) étant partiellement inséré dans la pièce d'actionnement (22), la pièce d'actionnement (22) étant configurée pour être déplacée pour passer, lorsque le dispositif de mesure (4) est installé sur le dispositif contacteur (2), d'une position libre dans laquelle l'ensemble de connexion (20) est isolé électriquement du dispositif contacteur (2) à une position bloquée dans laquelle l'ensemble de connexion (20) est en appui sur un desdits éléments de contact (18) du dispositif contacteur (2).

2. Dispositif de mesure selon la revendication 1, dans lequel ladite pièce d'actionnement (22) est configurée pour être translatée selon un axe (A) donné et tournée d'un quart de tour autour dudit axe (A) pour passer respectivement de la position libre à la position bloqué et vice-versa.

3. Dispositif de mesure selon la revendication 2, dans lequel le boîtier (12) comporte un capot (17), le capot (17) comportant N réceptacles de guidage (32), la pièce d'actionnement (22) étant insérée dans un desdits réceptacles de guidage (32) et étant configurée pour être guidée en translation dans ledit réceptacle de guidage (32), et dans lequel la pièce d'actionnement (22) comporte au moins un ergot de maintien (34), ledit ergot de maintien (34) étant configuré pour s'insérer, après translation et rotation autour dudit axe (A), dans un logement de maintien (36) correspondant formé dans le capot (17).

4. Dispositif de mesure selon l'une quelconque des revendications 1 à 3, dans lequel l'ensemble de connexion (20) comporte un élément conducteur (38) et un fourreau isolant (42), le fourreau isolant (42) entourant en partie l'élément conducteur (38), l'élément conducteur (38) comportant en outre une pointe de touche configurée pour venir en appui sur l'élément de contact (18) en position bloquée.

5. Dispositif de mesure selon la revendication 4, dans lequel chaque nappe flexible (26) comporte un œillet d'extrémité (50) en matériau conducteur, agencé autour de l'ensemble de connexion (20) associé, de sorte à conduire un signal électrique entre ledit ensemble de connexion (20) et l'unité de contrôle électronique (24) lorsque la pièce d'actionnement (22) est en position bloquée.

6. Dispositif de mesure selon la revendication 4 ou 5, dans lequel l'élément conducteur (38) comporte un épaulement (44), le fourreau isolant étant positionné en appui sur ledit épaulement.

7. Dispositif de mesure selon la revendication 6 comportant en outre un premier ressort (46) et un deuxième ressort (48), lesdits premier ressort (46) et deuxième ressort (48) entourant l'ensemble de connexion (20) et étant disposés de part et d'autre dudit épaulement (44), le premier ressort (46) étant disposé entre la pièce d'actionnement (22) et ledit épaulement (44) de l'élément conducteur.

8. Dispositif de mesure selon la revendication 7 dépendant de la revendication 5, dans lequel le deuxième ressort (48) est en matériau conducteur, le deuxième ressort (48) étant configuré pour être en contact avec la nappe flexible (26) en position bloquée, le deuxième ressort (48) réalisant une connexion électrique entre l'élément conducteur (38) de l'ensemble de connexion et ladite nappe flexible (26).

9. Dispositif de mesure selon l'une quelconque des revendications 1 à 8, configuré en outre pour effectuer des mesures de courant pour chaque conducteur électrique.

10. Dispositif de mesure selon l'une quelconque des revendications 1 à 9, comportant en outre une interface de communication (72) pour permettre une connexion à un réseau de communication (74), l'interface de communication (72) étant configurée pour transmettre des messages (80) comportant lesdites mesures d'au moins une grandeur électrique à un dispositif de supervision (82) connecté audit réseau de communication (74).

11. Système de diagnostic (60) de fonctionnement d'une installation électrique, comportant un dispositif de mesure (4) conforme à l'une des revendications 1 à 10, le dispositif de mesure (4) étant installé sur un dispositif de contact (2) de ladite installation électrique, le système de diagnostic (60) comprenant également un dispositif de supervision (82), le dispositif de mesure (4) étant configuré pour transmettre des mesures d'au moins une grandeur électrique audit dispositif de supervision (82) via un réseau de communication, le dispositif de supervision (82) comportant un contrôleur (86) configuré pour effectuer des calculs de diagnostic de fonctionnement en fonction de l'au moins une mesure de grandeur électrique reçue.
